# FASCICULE DE BREVET EUROPEEN

(11) **EP 0 781 083 B1**
(45) Date de publication et mention de la délivrance du brevet: **31.01.2001**
(21) Numéro de dépôt: 96402745.2
(22) Date de dépôt: 16.12.1996
(51) Int. Cl.: H05K 7/14

(54) **Dispositif de guidage, d'entraînement et de verrouillage d'un tiroir d'équipement électrique ou électronique dans une armoire**
Vorrichtung zur Führung, zum Antreiben, und zur Verriegelung einer Schublade eines elektronischen oder elektrischen Gerätes in einem Schrank
Guiding-, push-in-, and locking means for an electrical or electronic equipment drawer in a cabinet

(30) Priorité: 19.12.1995 FR 9515067
(43) Date de publication de la demande: 25.06.1997
(73) Titulaire: EUROCOPTER, F-13725 Marignane Cédex (FR)
(72) Inventeur: Esperandieu, Jean Guy, 13116 Vernegues (FR); Sotiriou, Robert Paul José, 13127 Vitrolles (FR)
(74) Mandataire: Picard, Jean-Claude Georges

(56) Documents cités:
- EP-A- 0 337 856
- DE-B- 1 262 383
- GB-A- 2 015 828
- US-A- 5 010 426

## Description

La présente invention concerne un dispositif de guidage, d'entraînement et de verrouillage d'un tiroir d'équipement électrique ou électronique dans une armoire, les circuits du tiroir devant être reliés à ceux de l'armoire par accouplement des connecteurs du tiroir sur ceux de l'armoire (ou rack).

Le but de la présente invention est de simplifier les dispositifs existants, décrits par exemple dans le document EP-A-0 337 856 ou le document US 5 010 426, en diminuant en même temps le coût, tout en permettant un contrôle précis du guidage et surtout de la force d'insertion avec laquelle l'accouplement des connecteurs respectifs du tiroir et de l'armoire est réalisé. Il convient en effet de préserver ces connecteurs de tout effort excessif tout en surmontant les frottements engendrés par les joints d'étanchéité et les joints d'isolement vis-à-vis de l'environnement électromagnétique. Il convient également de prévoir des moyens de verrouillage simples et efficace du tiroir sur l'armoire lorsque la mise en place est terminée, ceci étant particulièrement important dans le cas d'équipements embarqués sur des aéronefs (calculateurs à bord d'hélicoptères par exemple).

A cet effet, un dispositif du type défini ci-dessus comporte, de façon connue en soi, des éléments de guidage du genre à glissière et coulisseau, l'un étant fixé sur l'armoire, l'autre sur le tiroir, pour participer au guidage relatif de l'un sur l'autre, le coulisseau et la glissière Comportant des pièces coopérantes, actionnables de l'extérieur par un mouvement de rotation d'un organe de commande manoeuvrable par levier limitateur de couple, par exemple une clé dynamométrique, de sorte à permettre de provoquer alors un mouvement de coulissement relatif desdits éléments, et donc du tiroir dans l'armoire, lorsque le coulisseau est engagé dans la glissière, ainsi que l'arrêt de ce mouvement lorsque la position d'insertion terminale et d'accouplement des connecteurs est atteinte, par suite du déclenchement de ladite clé ou levier, étant en outre prévus des moyens de verrouillage relatif desdites pièces coopérantes, agissant alors automatiquement pour assurer le blocage des pièces du coulisseau par rapport à celles de la glissière, et provoquer ainsi le verrouillage du tiroir en position connectée dans l'armoire, caractérisé en ce que lesdites pièces coopérantes sont du type à train de pignons et crémaillère(s), ledit organe de commande rotatif étant accouplé à un pignon d'entrée entraînant ledit train, et provoquant ainsi un mouvement de coulissement relatif entre lesdits éléments de guidage, le train de pignons solidaire d'un desdits éléments entraînant la ou les crémaillères solidaires de l'autre élément.

Avantageusement, ledit train de pignons est monté dans ladite glissière, laquelle est fixée sur ledit tiroir, et ledit coulisseau, fixé sur l'armoire, comporte deux crémaillères latérales propres à être engrenées par lesdits pignons lors de la mise en place du tiroir dans l'armoire et, respectivement, de l'engagement de ladite glissière sur ledit coulisseau.

Par exemple, ledit train de pignons de la glissière pourra comporter trois pignons, à savoir un pignon d'entrée accouplé audit organe de commande rotatif, et deux pignons latéraux engrenés d'une part l'un avec l'autre et d'autre part et respectivement avec lesdites crémaillères latérales du coulisseau.

Les moyens de verrouillage, eux également, pourront être réalisés de différentes façons.

Par exemple, et dans un mode de réalisation particulièrement simple et fiable, ne demandant qu'un minimum de matériel supplémentaire, on pourra prévoir, dans ladite glissière, une lame de ressort pivotante dont une extrémité forme un levier actionnable de l'extérieur et dont l'autre extrémité peut, en fin d'insertion, s'arc-bouter entre deux dents dudit pignon d'entrée, pour le bloquer et bloquer ainsi ledit train de pignons.

Dans un autre mode de réalisation, lorsque le train de pignons comporte au moins deux pignons latéraux engrenés l'un avec l'autre, on pourra mettre en oeuvre, dans ladite glissière, une tige de blocage déverrouillable de l'extérieur par poussée dudit levier limitateur de couple et portant à son extrémité interne un taquet coinceur propre, lors d'une poussée exercée élastiquement dans le sens inverse sur ladite tige, à se coincer entre les deux dits pignons latéraux pour en empêcher la rotation dans le sens permettant le coulissement de ladite glissière hors dudit coulisseau.

Grâce à cette disposition, on pourra facilement faire en sorte que la mise en place dudit levier limitateur de couple, pour procéder à l'extraction du tiroir, provoque automatiquement une poussée sur l'extrémité extérieure de cette tige, et donc la libération des deux pignons latéraux et le déverrouillage du mécanisme permettant le coulissement relatif de la glissière sur le coulisseau.

Dans encore un autre mode de réalisation on pourra prévoir que lesdits moyens de verrouillage comprennent un cliquet à bille monté rotatif sur ladite glissière et propre à s'engager par son extrémité entre deux dents dudit pignon d'entrée, automatiquement dès que l'opération d'insertion du tiroir est terminée, et à se déverrouiller par pivotement en sens inverse dès mise en place dudit levier limitateur de couple, pour l'extraction du tiroir.

Dans une variante de l'invention, les pièces coopérantes pourront être d'un autre type qu'à pignons engrenant dans des crémaillères.

On pourra utiliser par exemple, sur lesdits éléments de guidage, des pièces coopérantes (pièces remplaçant les pignons et crémaillères) du genre propre à assurer un déplacement relatif desdits éléments, dans un sens ou dans l'autre, par un effet de rampe.

Un dispositif conforme à l'invention telle que definie dans la revendication 7 est donc caractérisé en ce que l'un desdits éléments de guidage du genre à glissière et coulisseau porte un excentrique pourvu d'une rainure en arc de cercle s'ouvrant à la périphérie dudit excentrique, celui-ci pouvant être actionnable de l'extérieur par le mouvement de rotation dudit organe de commande, et en ce que l'autre élément de guidage porte un plot propre à être engagé par l'extrémité ouverte de ladite rainure lors de l'engagement d'un desdits éléments de guidage sur l'autre, par suite de quoi la mise en rotation dudit excentrique provoquera, par effet de rampe entre ladite rainure et ledit plot, l'avancement d'un desdits éléments sur l'autre, jusqu'à ce que ledit plot atteigne le fond de ladite rainure, et donc jusqu'à l'insertion complète du tiroir dans l'armoire, tandis qu'une rotation de l'excentrique en sens inverse provoquera l'extraction de ces deux éléments l'un par rapport à l'autre et donc la sortie dudit tiroir.

Dans ce cas il est avantageux de prévoir que ledit excentrique, actionnable par ledit organe de commande et donc par le levier limitateur de couple, est porté par ladite glissière, et que ledit plot, monté sur le coulisseau, porte une bague tournante propre à limiter les frottements.

Un tel dispositif peut encore être caractérisé en ce que ledit excentrique porte un trou arqué par l'intermédiaire duquel il est monté pivotant sur son axe, de sorte qu'en fin de course, à savoir lorsque ledit plot parvient en butée au fond de la rainure en arc de cercle de l'excentrique, une rotation supplémentaire de l'excentrique par l'intermédiaire dudit organe de commande provoque le déplacement relatif dudit axe d'une extrémité à l'autre dudit trou arqué, et par suite le blocage de l'excentrique en rotation, verrouillant ainsi ledit tiroir en position d'insertion dans ladite armoire, ce verrouillage pouvant être complété par un cliquet élastique bloquant l'axe de l'excentrique dans ledit trou arqué.

Ces modes de réalisation de l'invention vont maintenant être décrits à titre d'exemples nullement limitatifs avec référence aux figures du dessin annexé dans lequel :
- la figure 1 représente schématiquement et en perspective un compartiment d'armoire, rack ou analogue, dans lequel on veut réaliser l'insertion contrôlée d'un tiroir ou boîtier d'équipement, électrique, électronique ou analogue ;
- la figure 2 représente en perspective l'assemblage glissière-coulisseau des éléments de guidage ;
- les figures 3 et 4 sont des vues en plan, respectivement du coulisseau et de la glissière ;
- la figure 3a est une vue en coupe transversale par la ligne III-III de la figure 3 ;
- la figure 4a est une vue en coupe transversale par la ligne IV-IV de la figure 4 ;
- la figure 5 est une vue en plan montrant le début de l'introduction de la glissière du tiroir sur le coulisseau de l'armoire ;
- la figure 6 est une vue analogue à la précédente à la fin de l'insertion, avec mise en oeuvre des moyens de verrouillage ;
- la figure 7 montre en plan une variante des moyens de verrouillage, en position en cours d'insertion, c'est-à-dire en position déverrouillée ;
- la figure 7a montre le détail des moyens de verrouillage en cours d'insertion ;
- la figure 8 est une vue analogue à celle de la figure 7 mais en position de fin d'insertion avec blocage des moyens de verrouillage ;
- la figure 8a montre le détail des moyens de verrouillage en position de blocage ;
- les figures 9 et 10 sont des vues en plan respectivement analogues à celles des figures 7 et 8, montrant encore d'autres moyens de verrouillage en position déverrouillée (figure 9) et verrouillée (figure 10) ;
- la figure 11 montre en plan un autre type de coulisseau, sans crémaillères ;
- la figure 12 montre en plan un autre type de glissière, du type à excentrique ;
- la figure 13 montre en plan le début de l'insertion de la glissière sur le coulisseau ;
- la figure 14 est une vue analogue à celle de la figure 13 en fin d'insertion ; et
- la figure 15 est encore une vue en plan analogue à celle des figures 13 et 14, montrant le verrouillage de l'excentrique.

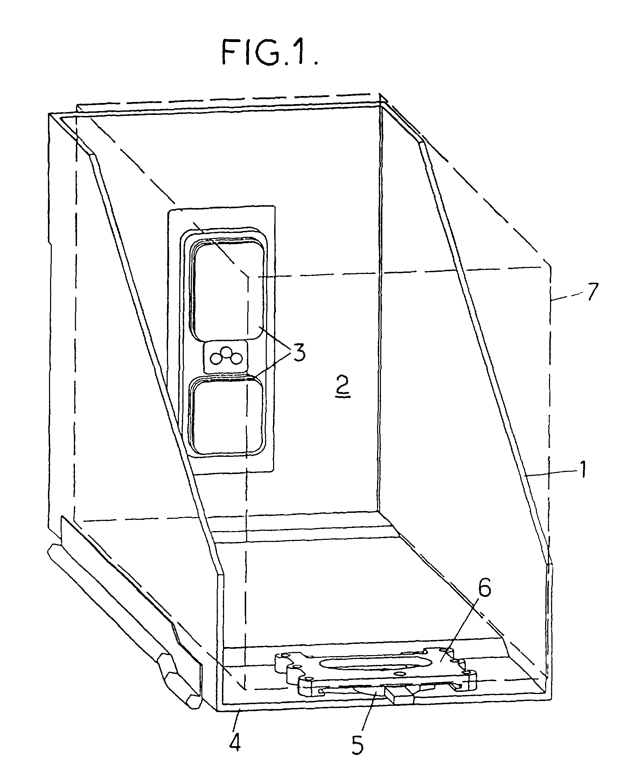

A la figure 1, le compartiment d'armoire est référencé en 1 et porte sur son fond 2 des embases de connection 3. Sur le plancher de support 4 de ce compartiment et à proximité de son bord est assujetti un élément de guidage 5 constitué d'un coulisseau à crémaillères, sur lequel est engagé un autre élément de guidage 6 constitué d'une glissière à train d'engrenages, fixée sur le boîtier ou tiroir 7. Les figures suivantes décrivent ces deux éléments de guidage ainsi que les moyens permettant d'assurer leur verrouillage relatif en fin de course, lorsque le tiroir 7 est entièrement inséré dans l'armoire et que ses connecteurs (non représentés) sont en prise avec les embases de connection 3 du rack.

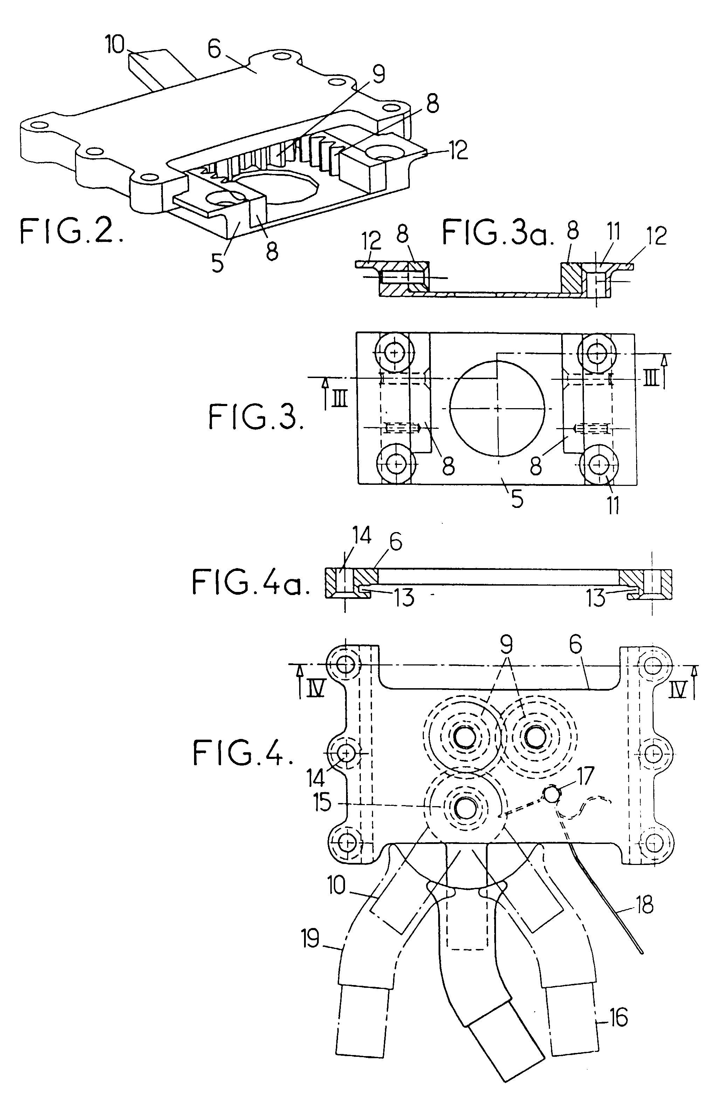

La figure 2 montre des crémaillères internes et latérales 8 du coulisseau 5 et permet d'apercevoir aussi les pignons latéraux 9 de la glissière, et l'extrémité de l'organe de commande 10, organes mieux visibles sur les autres figures.

Le coulisseau 5 est percé de quatre trous 11 permettant sa fixation par vis sur le plancher de support 4 de l'armoire, et comporte deux ailes latérales 12 servant de coulisses pour des rainures correspondantes 13 de la glissière 6, laquelle comporte six trous 14 pour sa fixation sur le fond du boîtier d'équipement 7.

On voit sur la figure 4 que la glissière porte les axes d'un train de trois pignons, à savoir un pignon d'entrée 15 sur lequel est calé l'organe de commande 10, et les deux pignons latéraux 9 cités plus haut, mutuellement en prise (figure 4) et dont l'un est en prise avec le pignon d'entrée 15. Sur l'organe 10 peut être engagée une clé dynamométrique 16 constituant ce que l'on a appelé plus haut le levier limitateur de couple. Enfin la glissière 6 porte un plot 17 sur lequel est encliqueté un ressort à lame 18 dont la grande extrémité est accessible de l'extérieur et dont l'autre, plus courte, peut venir s'arc-bouter entre deux dents du pignon 15.

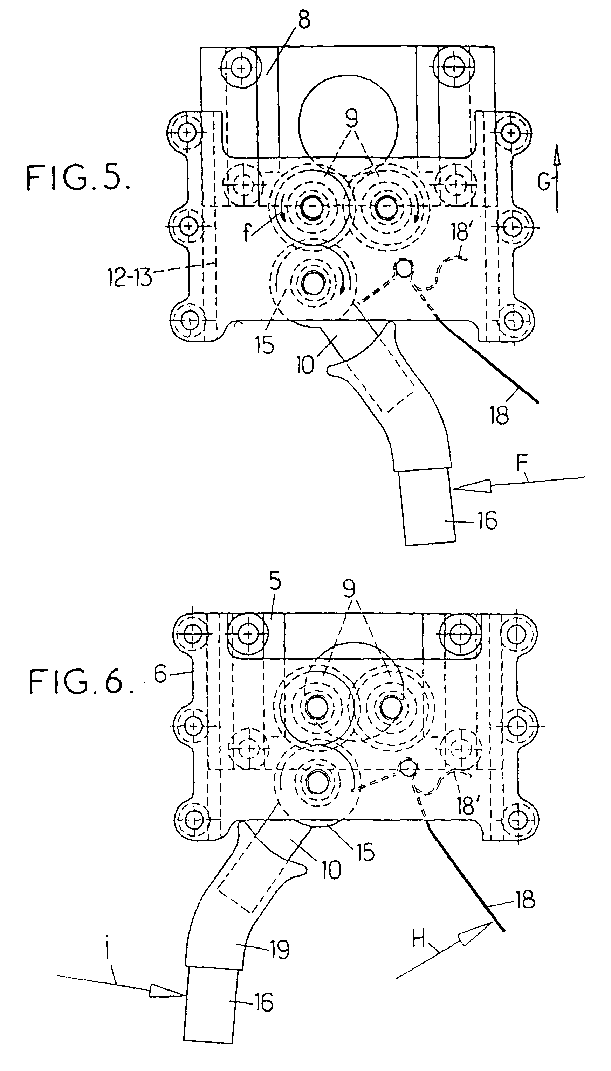

Ceci étant, on introduit le tiroir 7 dans l'armoire, en engageant la glissière 6 sur le coulisseau 5. En faisant pivoter la clé dynamométrique 16 dans le sens de la flèche F (figure 5), les pignons 15 et 9 du train d'engrenages pivoteront dans le sens des flèches f, et les pignons 9, engrenant dans les crémaillères latérales 8 du coulisseau 5, entraîneront la glissière dans le sens de la flèche G, le coulisseau étant fixe, ceci jusqu'en fin d'insertion (figure 6). La clé dynamométrique évitera par son déclenchement un excès d'effort en fin de course, ce qui préservera les connecteurs sur le tiroir et sur l'armoire. Le fait que la clé dynamométrique 16 soit connectée à l'organe 10 par l'intermédiaire d'un embout coudé 19 permet par retournement de limiter l'angle de débattement si nécessaire. Dans la position finale de la figure 6, le verrouillage en fin de course sera automatiquement assuré, du fait de la butée d'une aile 18' du ressort 18 sur l'extrémité du coulisseau 5, par pivotement du ressort 18 sur son plot 17 et encliquetage de l'extrémité intérieure de ce ressort 18 entre deux dents du pignon d'entrée 15, bloquant ainsi par son arc-boutement la rotation des pignons latéraux 9.

Pour extraire ensuite le tiroir il suffira de déverrouiller le ressort 18 en poussant son extrémité extérieure dans le sens de la flèche H puis la clé dynamométrique 16 dans le sens de la flèche I, ce qui fera tourner les pignons dans le sens inverse à celui des flèches f, et fera coulisser la glissière 6 dans le sens inverse à celui de la flèche G.

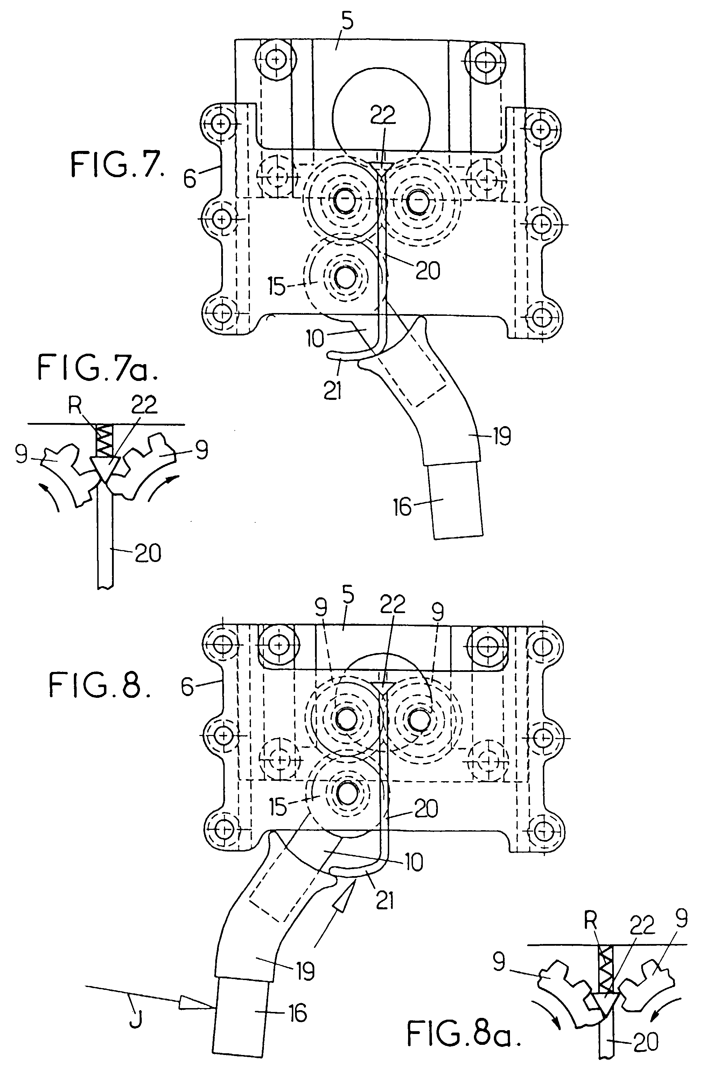

Dans le mode de réalisation des figures 7 et 8, 7a et 8a, les pièces coopérantes (crémaillères et train de pignons) sont du même type que précédemment, la variante ne concernant que les moyens de verrouillage. Ceux-ci comprennent ici une tige de blocage 20 manoeuvrable de l'extérieur grâce à un crochet courbé 21 et portant à son extrémité intérieure opposée un taquet coinceur 22 propre à se coincer entre les deux pignons latéraux 9 (du côté "avalant") en fin d'insertion (figure 8a), sous l'effet d'un ressort de rappel R. La mise en place de la clé dynamométrique 16 sur l'organe de commande 10 pour effectuer l'extraction du tiroir, et le déplacement de l'embout coudé 19 de la gauche vers la droite (flèche J sur la figure 8) provoqueront la poussée du crochet 21 vers l'avant et donc le décoincement du taquet 22 et le déverrouillage des pignons 9 de la glissière 6, autorisant leur pivotement dans les crémaillères du coulisseau 5.

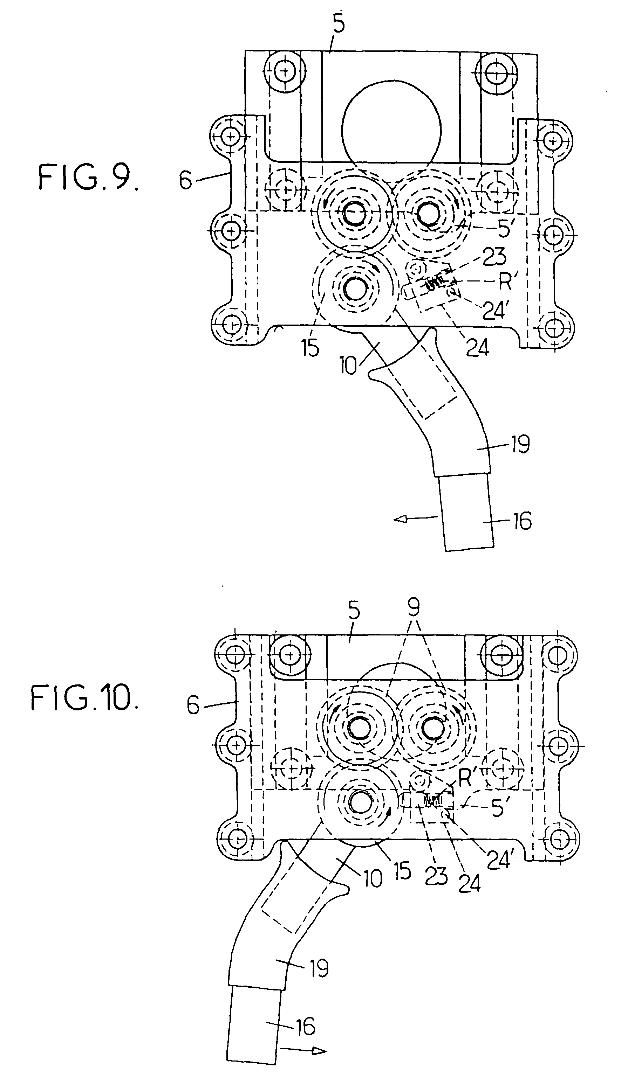

Dans le mode de réalisation des figures 9 et 10 on a représenté encore d'autres moyens de verrouillage, faisant appel à un cliquet à bille 23 rappelé par un ressort R' et monté dans un boîtier pivotant 24 de la glissière 6. Dans ce mode de réalisation, le coulisseau 5 porte sur son extrémité avant une saillie 5' qui en fin d'insertion (figure 10) sert de butée à un pion 24' du boîtier 24 et le fait pivoter (sens horaire), l'extrémité du cliquet 23 venant alors en prise entre deux dents du pignon d'entrée 15 pour le bloquer. Pour l'extraction du tiroir, la mise en place de la clé dynamométrique provoque, par rotation du pignon 15 dans le sens inverse, le rappel de la glissière 6 vers l'avant et l'effacement du cliquet 23 par retour du boîtier 24 à la position de déverrouillage de la figure 9.

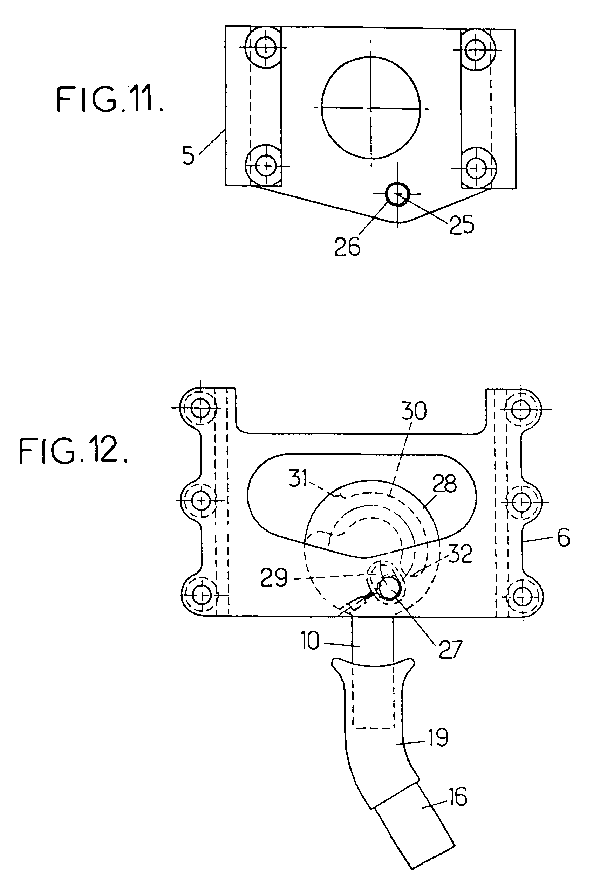

Aux figures 11 à 15 on a montré la possibilité d'utiliser d'autres types de pièces coopérantes, remplaçant le système à pignons et crémaillères pour provoquer le coulissement relatif, dans un sens ou dans l'autre, du coulisseau et de la glissière, le coulisseau pouvant rester fixé au plancher 4 de l'armoire 1, et la glissière au fond du tiroir 7. Pour simplifier on a utilisé les mêmes références que précédemment pour désigner le coulisseau, la glissière, l'organe de commande, la clé dynamométrique et son embout. On a adopté ici un effet de rampe. A cet effet, le coulisseau 5 porte un plot 25 équipé, pour la limitation des frottements, d'une bague tournante 26 ; le coulisseau 5 a par ailleurs la même forme extérieure que précédemment, ou une forme analogue, et il en est de même pour la glissière 6. Cette dernière porte quant à elle un axe de pivotement 27 pour un excentrique 28, lequel est monté sur cet axe par l'intermédiaire d'un trou arqué 29. L'excentrique est creusé d'une rainure en arc de cercle 30 s'ouvrant à sa périphérie par une embouchure 31 et possédant à son extrémité opposée un fond 32.

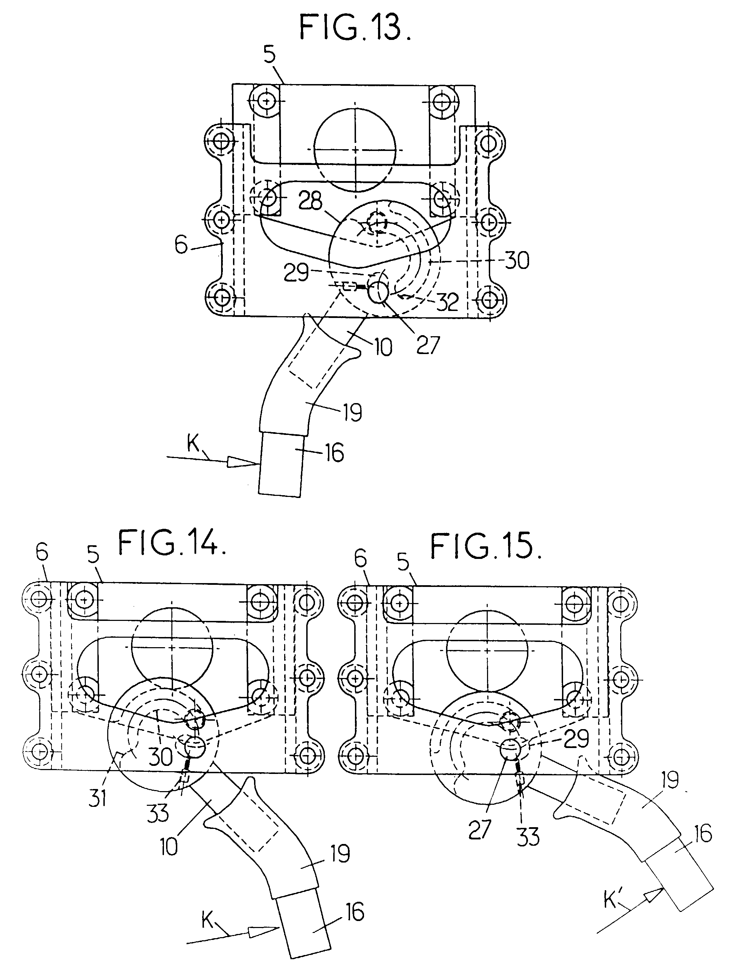

Ceci étant, on commence l'insertion de la glissière 6 sur le coulisseau 5 en orientant l'organe de commande 10 de telle sorte que l'embouchure 31 de la rainure 30 se présente en face du plot 25-26 et puisse venir le coiffer (figure 13). La rotation de la clé dynamométrique 16 et donc de l'organe 10 dans le sens de la flèche K fera alors tourner l'excentrique 28 sur son axe 27 dans le sens antihoraire, l'extrémité droite du trou oblong 29 s'appuyant sur l'axe 27, et le déplacement du plot 25-26 dans la rainure 30 provoquera progressivement l'avancée de la glissière 6, puis son engagement complet sur le coulisseau 5 (figure 14). Le plot 25-26 est alors en butée sur le fond 32 de la rainure 30. Une rotation supplémentaire de la clé (flèche K', figure 15) déplacera l'excentrique 28 légèrement vers la droite, jusqu'à la butée de l'extrémité gauche de son trou oblong 29 sur l'axe 27, ce qui empêchera toute rotation de l'excentrique dans le sens inverse, et assurera donc le verrouillage de la glissière 6 sur le coulisseau 5. Ce verrouillage peut être complété par un cliquet élastique 33 bloquant alors l'axe 27 dans cette position. Après déblocage, la rotation de l'organe de commande 10 en sens inverse permettra d'obtenir commodément l'extraction du tiroir, comme précédemment.

## Revendications

1. Dispositif de guidage, d'entraînement et de verrouillage d'un tiroir d'équipement électrique ou électronique dans une armoire, les circuits du tiroir devant être reliés à ceux de l'armoire par accouplement des connecteurs du tiroir sur ceux de l'armoire, ce dispositif comportant des éléments de guidage du genre à glissière (6) et coulisseau (5), l'un étant fixé sur l'armoire (1), l'autre sur le tiroir (7), pour participer au guidage relatif de l'un sur l'autre, le coulisseau (5) et la glissière (6) comportant des pièces coopérantes, actionnables de l'extérieur par un mouvement de rotation d'un organe de commande manoeuvrable par levier limitateur de couple (16), de sorte à permettre de provoquer alors un mouvement de coulissement relatif desdits éléments (5, 6), et donc du tiroir dans l'armoire, lorsque le coulisseau (5) est engagé dans la glissière (6), ainsi que l'arrêt de ce mouvement lorsque la position d'insertion terminale et d'accouplement des connecteurs est atteinte, par suite du déclenchement dudit levier, étant en outre prévus des moyens de verrouillage relatif (15, 18) desdites pièces coopérantes (8, 9), agissant alors automatiquement pour assurer le blocage des pièces du coulisseau (5) par rapport à celles de la glissière (6), et provoquer ainsi le verrouillage du tiroir (7) en position connectée dans l'armoire (1), caractérisé en ce que lesdites pièces coopérantes sont du type à train de pignons (9-15) et crémaillère(s) (8), ledit organe de commande rotatif (9) étant accouplé à un pignon d'entrée (15) entraînant ledit train, et provoquant ainsi un mouvement de coulissement relatif entre lesdits éléments de guidage (5, 6), le train de pignons (9) solidaire d'un (6) desdits éléments entraînant la ou les crémaillères (8) solidaires de l'autre élément (5).

2. Dispositif selon la revendication 1, caractérisé en ce que ledit train de pignons (9-15) est monté dans ladite glissière (6), laquelle est fixée sur ledit tiroir (7), et en ce que ledit coulisseau (5), fixé sur l'armoire (1), comporte deux crémaillères latérales (8) propres à être engrenées par lesdits pignons (9) lors de la mise en place du tiroir (7) dans l'armoire (1) et, respectivement, de l'engagement de ladite glissière (6) sur ledit coulisseau (5).

3. Dispositif selon la revendication 2, caractérisé en ce que ledit train de pignons de la glissière (6) comporte trois pignons, à savoir un pignon d'entrée (15) accouplé audit organe de commande rotatif (10), et deux pignons latéraux (9) engrenés d'une part l'un avec l'autre et d'autre part et respectivement avec lesdites crémaillères latérales (8) du coulisseau (5).

4. Dispositif selon l'une quelconque des revendications 1 à 3, caractérisé en ce que lesdits moyens de verrouillage comprennent, dans ladite glissière, une lame de ressort pivotante (18) dont une extrémité forme un levier actionnable de l'extérieur et dont l'autre extrémité peut, en fin d'insertion, s'arc-bouter entre deux dents dudit pignon d'entrée (15), pour le bloquer et bloquer ainsi ledit train de pignons (9, 15).

5. Dispositif selon la revendication 3, caractérisé en ce que lesdits moyens de verrouillage comprennent, dans ladite glissière, une tige de blocage (20) déverrouillable de l'extérieur par poussée dudit levier limitateur de couple (16) et portant à son extrémité interne un taquet coinceur (22) propre, lors d'une poussée exercée élastiquement dans le sens inverse sur ladite tige, à se coincer entre les deux dits pignons latéraux (9) pour en empêcher la rotation dans le sens permettant le coulissement de ladite glissière (6) hors dudit coulisseau (5).

6. Dispositif selon l'une quelconque des revendications 1 à 3, caractérisé en ce que lesdits moyens de verrouillage comprennent un cliquet à bille (23, 24) monté rotatif sur ladite glissière (6) et propre à s'engager par son extrémité entre deux dents dudit pignon d'entrée (15), automatiquement dès que l'opération d'insertion du tiroir (7) est terminée, et à se déverrouiller par pivotement en sens inverse dès mise en place de dudit levier limitateur de couple pour l'extraction du tiroir.

7. Dispositif de guidage, d'entraînement et de verrouillage d'un tiroir d'équipement électrique ou électronique dans une armoire, les circuits du tiroir devant être reliés à ceux de l'armoire par accouplement des connecteurs du tiroir sur ceux de l'armoire, ce dispositif comportant des éléments de guidage du genre à glissière (6) et coulisseau (5), l'un étant fixé sur l'armoire (1), l'autre sur le tiroir (7), pour participer au guidage relatif de l'un sur l'autre, le coulisseau (5) et la glissière (6) comportant des pièces coopérantes, actionnables de l'extérieur par un mouvement de rotation d'un organe de commande manoeuvrable par levier limitateur de couple (16), de sorte à permettre de provoquer alors un mouvement de coulissement relatif desdits éléments (5, 6), et donc du tiroir dans l'armoire, lorsque le coulisseau (5) est engagé dans la glissière (6), ainsi que l'arrêt de ce mouvement lorsque la position d'insertion terminale et d'accouplement des connecteurs est atteinte, par suite du déclenchement dudit levier, étant en outre prévus des moyens de verrouillage relatif (15, 18) desdites pièces coopérantes (8, 9), agissant alors automatiquement pour assurer le blocage des pièces du coulisseau (5) par rapport à celles de la glissière (6), et provoquer ainsi le verrouillage du tiroir (7) en position connectée dans l'armoire (1), caractérisé en ce que lesdites pièces coopérantes sont du genre à effet de rampe, l'un (6) desdits éléments de guidage du genre à glissière et coulisseau portant un excentrique (28) pourvu d'une rainure en arc de cercle (30) s'ouvrant à la périphérie dudit excentrique (en 31), celui-ci pouvant être actionnable de l'extérieur par le mouvement de rotation dudit organe de commande (10), et l'autre (5) élément de guidage portant un plot (25) propre à être engagé par l'extrémité ouverte (31) de ladite rainure (30) lors de l'engagement d'un (6) desdits éléments de guidage sur l'autre (5), par suite de quoi la mise en rotation dudit excentrique (28) provoquera, par effet de rampe entre ladite rainure (30) et ledit plot (25), l'avancement d'un (6) desdits éléments sur l'autre (5), jusqu'à ce que ledit plot (25) atteigne le fond (32) de ladite rainure (30), et donc jusqu'à l'insertion complète du tiroir (7) dans l'armoire (1), tandis qu'une rotation de l'excentrique (28) en sens inverse provoquera l'extraction de ces deux éléments l'un par rapport à l'autre et donc la sortie dudit tiroir (7).

8. Dispositif selon la revendication 7, caractérisé en ce que ledit excentrique (28), actionnable par ledit organe de commande (10) et donc par le levier limitateur de couple (16), est porté par ladite glissière (6), et en ce que ledit plot (25), monté sur le coulisseau (5), porte une bague tournante (26) propre à limiter les frottements.

9. Dispositif selon la revendication 7 ou 8, caractérisé en ce que ledit excentrique (28) porte un trou arqué (29) par l'intermédiaire duquel il est monté pivotant sur son axe (27), de sorte qu'en fin de course, à savoir lorsque ledit plot (25) parvient en butée au fond (32) de la rainure en arc de cercle (30) de l'excentrique (28), une rotation supplémentaire de l'excentrique (28) par l'intermédiaire dudit organe de commande (10) provoque le déplacement relatif dudit axe (27) d'une extrémité à l'autre dudit trou arqué (29), et par suite le blocage de l'excentrique (28) en rotation, verrouillant ainsi ledit tiroir (7) en position d'insertion dans ladite armoire (1), ce verrouillage pouvant être complété par un cliquet élastique (33) bloquant l'axe (27) de l'excentrique (28) dans ledit trou arqué (29).

## Patentansprüche

1. Vorrichtung zur Führung, zum Antrieb und zur Verriegelung eines elektrischen oder elektronischen Ausrüstungseinschubs in einem Schrank, wobei die Schaltungen des Einschubs mit denjenigen des Schranks durch Verkupplung der Steckverbinder des Einschubs mit denjenigen des Schranks verbunden werden sollen, wobei diese Vorrichtung Führungselemente nach Art einer Laufschiene (6) und eines Laufstücks (5) enthält, von denen das eine am Schrank (1) und das andere am Einschub (7) zur Beteiligung bei der relativen Führung des einen am anderen befestigt ist, wobei das Laufstück (5) und die Laufschiene (6) zusammenwirkende Teile haben, die von außen durch eine Drehbewegung eines über einen Drehmomentbegrenzerhebel (16) bedienbaren Steuerorgans betätigbar sind, um dann, wenn das Laufstück (5) in der Laufschiene (6) eingesetzt ist, das Herbeiführen einer relativen Verschiebebewegung der Elemente (5, 6) und somit des Einschubs im Schrank sowie das Anhalten dieser Bewegung, wenn die Endeinschiebeposition und die Verkupplung der Steckverbinder erreicht ist, infolge der Auslösung des Hebels zu ermöglichen, wobei außerdem Mittel (15, 18) zur relativen Verriegelung der zusammenwirkenden Teile (8, 9) vorgesehen sind, die dann automatisch tätig werden, um die Sperrung der Teile des Laufstücks (5) in bezug auf diejenigen der Laufschiene (6) sicherzustellen und somit die Verriegelung des Einschubs (7) im Schrank (1) in angeschlossener Position herbeizuführen, **dadurch gekennzeichnet**, daß die zusammenwirkenden Teile von der Art eines Zahnräderwerks (9-15) und Zahnstange(n) (8) sind, wobei das drehbare Steuerorgan (9) an ein das Zahnräderwerk antreibendes Eingangszahnrad (15) angekoppelt ist und somit eine relative Verschiebebewegung zwischen den Führungselementen (5,6) herbeiführt, wobei das mit einem (6) der Elemente übereinstimmende Zahnräderwerk (9) die mit dem anderen Element (5) übereinstimmende(n) Zahnstange(n) (8) antreibt.

2. Vorrichtung nach Anspruch 1, **dadurch gekennzeichnet**, daß das Zahnräderwerk (9-15) in der Laufschiene (6) angebracht ist, welche am Einschub (7) befestigt ist, und daß das am Schrank (1) befestigte Laufstück (5) zwei seitliche Zahnstangen (8) enthält, die dazu geeignet sind, von den Zahnrädern (9) bei Instellungbringen des Einschubs (7) im Schrank (1) bzw. bei Einsetzen der Laufschiene (6) am Laufstück (5) in Eingriff genommen zu werden.

3. Vorrichtung nach Anspruch 2, **dadurch gekennzeichnet**, daß das Zahnräderwerk der Laufschiene (6) drei Zahnräder umfaßt, d.h. ein an das drehbare Steuerorgan (10) angekoppeltes Eingangszahnrad (15) und zwei seitliche Zahnräder (9), die einerseits miteinander und andererseits und jeweils mit den seitlichen Zahnstangen (8) des Laufstücks (5) in Eingriff stehen.

4. Vorrichtung nach einem der Ansprüche 1 bis 3, **dadurch gekennzeichnet**, daß die Mittel zur Verriegelung bei der Laufschiene ein schwenkbares Federblatt (18) umfassen, dessen eines Ende einen von außen betätigbaren Hebel bildet und dessen anderes Ende sich am Schluß des Einbaus zwischen zwei Zähnen des Eingangszahnrads (15) verspreizen kann, um dieses und somit das Zahnräderwerk (9, 15) zu sperren.

5. Vorrichtung nach Anspruch 3, **dadurch gekennzeichnet**, daß die Mittel zur Verriegelung bei der Laufschiene einen Sperrstift (20) enthalten, der von außen durch Schub des Drehmomentbegrenzerhebels (16) entriegelbar ist und an seinem inneren Ende eine besondere Verkeilnase (22) zur Verkeilung zwischen den beiden seitlichen Zahnrädern (9) bei einem in umgekehrter Richtung auf den Stift elastisch ausgeübten Schub trägt, um dadurch die Drehung in der Richtung zu verhindern, welche das Verschieben der Laufschiene (6) außerhalb des Laufstücks (5) ermöglicht.

6. Vorrichtung nach einem der Ansprüche 1 bis 3, **dadurch gekennzeichnet**, daß die Mittel zur Verriegelung eine Kugelklinke (23, 24) umfassen, die drehbar an der Laufschiene (6) angebracht und dazu geeignet ist, sich mit ihrem Ende zwischen zwei Zähnen des Eingangszahnrads (15) automatisch in Eingriff zu bringen, sobald der Vorgang des Einbaus des Einschubs (7) beendet ist, und sich durch Schwenkung in umgekehrter Richtung gleich nach der Instellungbringung des Drehmomentbegrenzerhebels für das Herausziehen des Einschubs zu entriegeln.

7. Vorrichtung zur Führung, zum Antrieb und zur Verriegelung eines elektrischen oder elektronischen Ausrüstungseinschubs in einem Schrank, wobei die Schaltungen des Einschubs mit denjenigen des Schranks durch Verkupplung der Steckverbinder des Einschubs mit denjenigen des Schranks verbunden werden sollen, wobei diese Vorrichtung Führungselemente nach Art einer Laufschiene (6) und eines Laufstücks (5) enthält, von denen das eine am Schrank (1) und das andere am Einschub (7) zur Beteiligung bei der relativen Führung des einen am anderen befestigt ist, wobei das Laufstück (5) und die Laufschiene (6) zusammenwirkende Teile haben, die von außen durch eine Drehbewegung eines über einen Drehmomentbegrenzerhebel (16) bedienbaren Steuerorgans betätigbar sind, um dann, wenn das Laufstück (5) in der Laufschiene (6) eingesetzt ist, das Herbeiführen einer relativen Verschiebebewegung der Elemente (5, 6) und somit des Einschubs im Schrank sowie das Anhalten dieser Bewegung, wenn die Endeinschiebeposition und die Verkupplung der Steckverbinder erreicht ist, infolge der Auslösung des Hebels zu ermöglichen, wobei außerdem Mittel (15, 18) zur relativen Verriegelung der zusammenwirkenden Teile (8, 9) vorgesehen sind, die dann automatisch tätig werden, um die Sperrung der Teile des Laufstücks (5) in bezug auf diejenigen der Laufschiene (6) sicherzustellen und somit die Verriegelung des Einschubs (7) im Schrank (1) in angeschlossener Position herbeizuführen, **dadurch gekennzeichnet**, daß die zusammenwirkenden Teile einen Rampeneffekt ausnutzen, wobei das eine (6) der durch die Laufschiene und das Laufstück gebildeten Führungselemente einen Exzenter (28) trägt, der mit einer kreisbogenförmigen Rille (30) versehen ist, die sich am Rand des Exzenters (bei 31) öffnet, wobei dieser von außen durch die Drehbewegung des Steuerorgans (10) betätigbar ist, und wobei das andere Führungselement (5) einen Stummel (25) trägt, der dazu geeignet ist, durch das offene Ende (31) der Rille (30) bei Ineinandergreifen der beiden Führungselemente (5, 6) in Eingriff genommen zu werden, infolgedessen das Verdrehen des Exzenters (28) durch den Rampeneffekt zwischen der Rille (30) und dem Stummel (25) das Vorrücken eines (6) der Elemente am anderen (5) herbeiführt, bis der Stummel (25) das geschlossene Ende (32) der Rille (30) erreicht hat und somit bis zur vollständigen Einführung des Einschubs (7) im Schrank (1), wogegen eine Drehung des Exzenters (28) in umgekehrter Richtung das Auseinanderziehen dieser beiden Elemente und damit die Ausgabe des Einschubs (7) hervorruft.

8. Vorrichtung nach Anspruch 7, **dadurch gekennzeichnet**, daß der Exzenter (28), der durch das Steuerorgan (10) und damit durch den Drehmomentbegrenzerhebel (16) betätigbar ist, von der Laufschiene (6) getragen ist und daß der Stummel (25), der am Laufstück (5) angebracht ist, einen umlaufenden Ring (26) trägt, der zur Begrenzung der Reibungen geeignet ist.

9. Vorrichtung nach Anspruch 7 oder 8, **dadurch gekennzeichnet**, daß der Exzenter (28) ein bogenförmiges Loch (29) trägt, mittels welchem er schwenkbar an seiner Achse (27) angebracht ist, so daß in der Endstellung, d.h. wenn der Stummel (25) am geschlossenen Ende (32) der kreisbogenförmigen Rille (30) des Exzenters (28) anschlägt, eine zusätzliche Drehung des Exzenters (28) mit Hilfe des Steuerorgans (10) die relative Verschiebung der Achse (27) von einem Ende des bogenförmigen Lochs (29) zum anderen und demzufolge die Drehsperrung des Exzenters (28) hervorruft, wodurch also der Einschub (7) in der Einbauposition im Schrank (1) verriegelt wird, wobei diese Verriegelung durch eine elastische Klinke (33) vervollständigt werden kann, welche die Achse (27) des Exzenters (28) im bogenförmigen Loch (29) sperrt.

## Claims

1. Device for guiding, driving, and locking a slot-in module of electrical or electronic equipment in a cabinet, it being necessary for the circuits of the slot-in module to be connected to those of the cabinet by coupling the connectors of the slot-in module to those of the cabinet, this device including guide elements of the sort having a slideway (6) and a slide (5), one being fixed to the cabinet (1), the other to the slot-in module (7), for playing a part in the relative guiding of one over the other, the slide (5) and the slideway (6) including interacting components which can be actuated from outside by a rotational movement of a control member that can be manoeuvred by a torque-limiting lever (16) in such a way as to then be able to cause a movement of relative sliding of the said elements (5, 6), and therefore of the slot-in module in the cabinet, when the slide (5) is engaged in the slideway (6), as well as to halt this movement when the end-of-insertion and connectors-coupled position is reached, after release of the said lever, means (15, 18) being also provided for relative locking of the said interacting components (8, 9), these then acting automatically in order to block the components of the slide (5) with respect to those of the slideway (6) and thus cause the slot-in module (7) to be locked in the cabinet (1) in the connected position, characterized in that the said interacting components are of the type having a set of pinions (9-15) and rack(s) (8), the said rotary control member (10) being coupled to an input pinion (15) driving the said set and thus causing a movement of relative sliding between the said guide elements (5, 6), the set of pinions (9) secured to one (6) of the said elements driving the rack or racks (8) secured to the other element (5).

2. Device according to Claim 1, characterized in that the said set of pinions (9-15) is mounted in the said slideway (6), which is fixed to the said slot-in module (7), and in that the said slide (5), fixed to the cabinet (1), includes two lateral racks (8) in which the said pinions (9) can mesh as the slot-in module (7) is being placed in the cabinet (1) and, respectively, as the said slideway (6) engages on the said slide (5).

3. Device according to Claim, 2, characterized in that the said set of pinions of the slideway (6) includes three pinions, namely an input pinion (15) coupled to the said rotary control member (10) and two lateral pinions (9) meshing on the one hand with one another and, on the other hand and respectively, with the said lateral racks (8) of the slide (5).

4. Device according to any one of Claims 1 to 3, characterized in that the said locking means comprise, in the said slideway, a pivoting spring leaf (18), one end of which forms a lever which can be actuated from the outside and the other end of which may, at the end of insertion, press up between two teeth of the said input pinion (15), in order to block it and thus block the said set of pinions (9, 15).

5. Device according to Claim 3, characterized in that the said locking means comprise, in the said slideway, a blocking rod (20) which can be unlocked from the outside by pushing the said torque-limiting lever (16) and which at its internal end carries a jamming dog (22) capable, when a thrust is exerted elastically in the opposite direction on the said rod, of jamming between the two said lateral pinions (9) in order to prevent them from rotating in the direction allowing the said slideway (6) to slide out of the said slide (5).

6. Device according to any one of Claims 1 to 3, characterized in that the said locking means comprise a ball catch (23, 24) mounted so that it can rotate on the said slideway (6) and capable of engaging via its end between two teeth of the said input pinion (15) automatically as soon as the operation of inserting the slot-in module (7) is over and of unlocking by pivoting in the opposite direction as soon as the said torque-limiting lever is put in place for extracting the slot-in module.

7. Device for guiding, driving, and locking a slot-in module of electrical or electronic equipment in a cabinet, it being necessary for the circuits of the slot-in module to be connected to those of the cabinet by coupling the connectors of the slot-in module to those of the cabinet, this device including guide elements of the sort having a slideway (6) and a slide (5), one being fixed to the cabinet (1), the other to the slot-in module (7), for playing a part in the relative guiding of one over the other, the slide (5) and the slideway (6) including interacting components which can be actuated from outside by a rotational movement of a control member that can be manoeuvred by a torque-limiting lever (16) in such a way as to then be able to cause a movement of relative sliding of the said elements (5, 6), and therefore of the slot-in module in the cabinet, when the slide (5) is engaged in the slideway (6), as well as to halt this movement when the end-of-insertion and connectors-coupled position is reached, after release of the said lever, means (15, 18) being also provided for relative locking of the said interacting components (8, 9), these then acting automatically in order to block the components of the slide (5) with respect to those of the slideway (6) and thus cause the slot-in module (7) to be locked in the cabinet (1) in the connected position, characterized in that the said interacting components are of the sort employing a ramp effect, one (6) of the said guide elements of the slideway-and-slide sort bearing an eccentric (28) provided with an arc-shaped slot (30) which opens at the periphery of the said eccentric (31), it being possible for this eccentric to be actuated from the outside by the rotational movement of the said control member (10), and the other (5) guide element bearing a peg (25) which can be engaged via the open end (31) of the said slot (30) when one (6) of the said guide elements is engaged on the other (5), after which rotation of the said eccentric (28) will, through a ramp effect between the said slot (30) and the said peg (25), cause one (6) of the said elements to advance along the other (5) until the said peg (25) reaches the closed end (32) of the said slot (30), and therefore until the slot-in module (7) is fully inserted in the cabinet (1), while a rotation of the eccentric (28) in the opposite direction will cause these two elements to be extracted, one with respect to the other, and therefore cause the said slot-in module (7) to come out.

8. Device according to claim 7, characterized in that the said eccentric (28), which can be actuated by the said control member (10) and therefore by the torque-limiting lever (16), is borne by the said slideway (6), and in that the said peg (25) mounted on the slide (5) bears a rotating ring (26) capable of limiting friction.

9. Device according to claim 7 or 8, characterized in that the said eccentric (28) has an arched hole (29) by means of which it is mounted so that it can pivot on its pin (27), in such a way that, at the end of travel, namely when the said peg (25) hits the closed end (32) of the arc-shaped slot (30) of the eccentric (28), an additional rotation of the eccentric (28) by means of the said control member (10) causes the relative travel of the said pin (27) from one end of the said arched hole (29) to the other and consequently the blocking of the rotation of the eccentric (28), thus locking the said slot-in module (7) in the position in which it is inserted into the said cabinet (1), it being possible for this locking to be supplemented by an elastic catch (33) blocking the pin (27) of the eccentric (28) in the said arched hole (29).
